# EUROPEAN PATENT APPLICATION

(11) **EP 0 750 112 A2**
(43) Date of publication of application: **27.12.1996**
(21) Application number: 96304410.2
(22) Date of filing: 13.06.1996
(51) Int. Cl.: F02P 3/055, H03K 17/0814

(54) **Tamper-resistant circuit and engine control system**

(30) Priority: 23.06.1995 GB 9512883
(71) Applicant: LUCAS INDUSTRIES public limited company, Solihull, West Midlands B90 4LA (GB)
(72) Inventor: Halmshaw, Raymond Paul, Redditch, B98 8HN (GB)
(74) Representative: Robinson, John Stuart

(57) **Abstract**

A tamper-resistant circuit is provided for controlling a load (3), such as an actuator of an internal combustion engine. The circuit comprises a semiconductor switch (6) controlled by a controller (8) for supplying the desired load current to the load. A link (11), such as a fusible link, is connected in series with the load (3) and is arranged to become open circuit at a current greater than the desired load current so as to prevent current supply to the load (3).

## Description

The present invention relates to a tamper-resistant circuit. Such a circuit may be used to prevent tampering with an actuator, for instance comprising part of a vehicle engine control system. The present invention also relates to an engine control system.

According to a first aspect of the invention, there is provided a tamper-resistant circuit, comprising: a load which, in use, requires a first current; a link which is arranged to become open circuit at a second current which is greater than the first current; and a control circuit arranged, when actuated, to supply the first current from an output thereof through the link and the load.

The control circuit may comprise a semiconductor switch connected in series with the link and the load and having a control electrode connected to a control means, such as a pulse width modulator, for controlling current through the semiconductor switch. A sensing element, such as a resistor, may be connected in series with the semiconductor switch, the link, and the load and connected to a control input of the modulator.

A first comparator may be arranged to switch on the semiconductor switch when the current through the link and the load exceeds a predetermined current which is greater than the first current.

A second comparator may be arranged to switch on the semiconductor switch when the voltage at a node of a series circuit comprising the semiconductor switch, the link, and the load exceeds a predetermined voltage.

A decoder may be connected to the control circuit.

A diode may be connected in series with the link and the load so as to block reverse current.

The semiconductor switch may comprise a bipolar transistor, or a field effect transistor such as a MOSFET.

The load may comprise an actuator, for instance forming part of a vehicle engine control system.

The circuit may be disposed within a tamper-resistant enclosure. The enclosure may be conductive and may form a common terminal of the circuit.

According to a second aspect of the invention, there is provided an engine control system including a circuit according to the first aspect of the invention, in which the load comprises an actuator.

The invention will be further described, by way of example, with reference to the accompanying drawings, in which:
Figure 1 is a circuit diagram of a conventional type of circuit; and
Figure 2 is a circuit diagram of a tamper-resistant circuit constituting an embodiment of the invention.

Like reference numerals refer to like parts in the drawings.

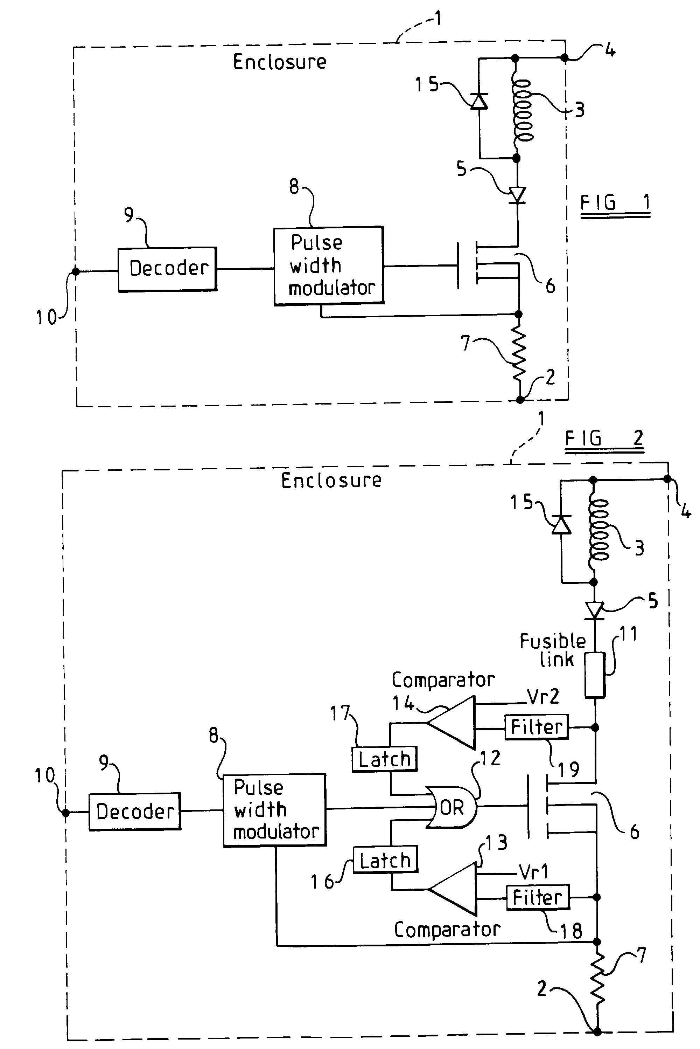

The circuit shown in Figure 1 comprises a tamper-resistant enclosure 1. For instance, the enclosure may comprise a steel box having a steel lid welded thereto so as to prevent or render difficult unauthorised access to the circuit within the enclosure 1.

The circuit further comprises an actuator 3, for instance of electromagnetic type forming part of an engine control system of a vehicle, having a recirculating diode 15 connected thereacross. The actuator may be part of the fuel system of a compression-ignition engine such that the engine cannot be operated unless the actuator 3 is enabled. The actuator is connected between a power supply terminal 4 in the form of a connector for supplying power to the circuit and, via a diode 5 for providing reverse supply polarity protection, to the drain of a power MOSFET 6, whose source is connected via a current sensing resistor 7 of very low value to a common terminal 2.

The MOSFET 6 has a gate connected to the output of a pulse width modulator 8 having a control input connected to the connection between the current sensing resistor 7 and the source of the MOSFET 6. An enable input of the pulse width modulator 8 is connected to the output of a decoder 9, whose input is connected to an input terminal 10 of the circuit in the form of a connector.

In use, the common terminal 2 is electrically connected to the common terminal of a vehicle supply system. The power supply terminal 4 is connected to the vehicle power supply, for instance via the vehicle ignition switch. The input terminal 10 is connected to a controller which controls operation of the engine.

In order for the engine to be capable of operation, the control system must be capable of controlling operation of the actuator 3 by controlling conduction of the MOSFET 6. Whenever the MOSFET 6 is to be switched on, encoded signals are supplied by the controller to the decoder 9 via the input terminal 10. The decoder 9 decodes the encoded signals and, if these are correctly encoded, actuates the pulse width modulator 8. The pulse width modulator 8 senses the current by monitoring the voltage across the current sensing resistor 7 and controls the pulse width of a pulse waveform supplied to the gate of the MOSFET 6 so as to control the current which flows through the source/drain path of the MOSFET 6, and hence via the diode 5 through the actuator 3.

If no signal or an incorrect encoded signal is supplied to the input terminal 10, this is detected by the decoder 9 and the pulse width modulator 8 will remain in the disabled state and thus prevents conduction of the MOSFET 6. The actuator 3 cannot therefore be operated unless the correctly encoded signals are supplied to the circuit. Thus, a potential vehicle thief who would not normally know the correct encoding would be unable to operate the engine by supplying signals to the input terminal 10.

Although the circuit shown in Figure 1 provides a high degree of resistance to tampering, it is possible for the circuit to be overridden by applying a relatively high voltage to the terminal 4 for a short duration. If a sufficiently large voltage is applied to the terminal 4 so that the maximum voltage rating of the source-drain path of the MOSFET 6 is exceeded, the MOSFET 6 will fail. In these circumstances, the source-drain path may fail open circuit or closed circuit and, if it fails closed circuit, the actuator 3 can then be operated without the thief needing to know the correct encoding for signals to the input terminal 10. In the case where the actuator 3 is of the type which is required to be continuously operated in order for the engine to be operated, a failure of this type defeats the tamper-resistant circuit shown in Figure 1 and the thief may then be able to drive the vehicle away.

By providing current drive to the actuator 3, a relatively low impedance actuator 3 may be used without requiring a MOSFET 6 of relatively high power rating. Additionally a low impedance actuator allows a high force to be generated for a short time. This force may be used to overcome any pressure in the system caused, for instance, during cranking.

The circuit shown in Figure 2 differs from that shown in Figure 1 in that various additional components are added so as to improve the tamper-resistance of the circuit. A fusible link 11, such as a conventional fuse, is connected between the diode 5 and the drain of the MOSFET 6. The gate of the MOSFET 6 is connected to the output of an OR gate 12 having first, second, and third inputs. The first input is connected to the output of the modulator 8, the second input is connected to the output of a latch 16 whose input is connected to the output of a comparator 13, and the third input is connected to the output of a latch 17 whose input is connected to the output of a comparator 14.

The comparator 13 has a non-inverting input connected via a filter 18 to the connection between the resistor 7 and the source of the MOSFET 6. An inverting input of the comparator 13 is connected to receive a first reference voltage Vr1. The comparator 14 has a non-inverting input connected via a filter 19 to the connection between the fusible link 11 and the drain of the MOSFET 6. An inverting input of the comparator 14 is connected to receive a second reference voltage Vr2. The filters 18 and 19 reduce noise and particularly transient voltages which may occur as interference from electrical systems of the vehicle and which might otherwise cause false triggering.

During normal operation, the circuit of Figure 2 operates in the same way as the circuit of Figure 1 and permits the actuator 3 to be actuated only when the correctly encoded signal is supplied to the input 10.

If a potential thief successfully causes the MOSFET 6 to fail with its source/drain path short-circuited or partially short-circuited, application of the normal working voltage to the terminal 4 will result in an excessive current being passed by the actuator 3. The fusible link 11 has a rating such that it passes the normal working current of the actuator 3 but goes open circuit at a predetermined current between the normal operating current of the actuator, as defined by the current drive provided by the pulse width modulator 8, and the current drawn by the actuator 3 with the MOSFET 6 short-circuited. Thus, even if the thief is successful in causing the MOSFET 6 to fail short-circuited or partially short-circuited, subsequent application of power to the terminal 4 causes the fusible link 11 to become open circuit so that the actuator 3 cannot be actuated.

As a further safeguard, the comparator 13 monitors the current passing through the actuator 3 by monitoring the voltage developed across the current sensing resistor 7. If the current exceeds a predetermined value defined by the first reference voltage Vr1, the comparator 13 actuates the latch 16 which turns on the MOSFET 6 via the gate 12 so that the fusible link 11 goes open circuit. Similarly, the comparator 14 monitors the voltage at the drain of the MOSFET 6. If this exceeds the second reference voltage Vr2, the comparator 14 actuates the latch 17 which switches on the MOSFET 6 via the gate 12. Again, this causes the actuator 3 and fusible link 11 to be connected across the power supply so that the fusible link 11 goes open circuit and the actuator 3 cannot be actuated. The latches 16 and 17 ensure that the MOSFET 6 is turned on for long enough to ensure that the fusible link 11 goes open circuit.

Various modifications may be made within the scope of the invention. For instance, the actuator 3 and/or the diode 5 and/or the fusible link 11 may be connected in the source circuit of the MOSFET 6 instead of in the drain circuit as shown. Similarly, the current sensing resistor 7 may be connected in the drain circuit instead of in the source circuit. The MOSFET 6 may be replaced by any other suitable device, such as a bipolar transistor of appropriate rating. The enclosure 1 may actually form part of the actuator 3 with the remaining components being provided therein.

The fusible link 11 may comprise a thermally actuated device which goes open circuit in response to a rise in temperature corresponding to currents greater than or equal to the predetermined current. The device may be automatically or manually resettable after a delay.

It is thus possible to provide a circuit which is highly resistant to tampering. In normal use, access to the contents of the enclosure 1 is prevented other than via the connectors 2, 4 and 10. Access to the connector 10 does not permit tampering unless the correct encoding of control signals is known.

The application of excessive voltages between the connectors 4 and 2 cannot be used to defeat the circuit. Even if a potential thief is successful in damaging the MOSFET 6 so that it becomes a permanent short circuit, the application of normal power between the terminals 4 and 2 will cause the fusible link 11 to become open circuit so that the actuator 3 cannot operate. Applying out-of-specification voltages to the terminals 4 and 2 results in either or both of the comparators 13 and 14 detecting out-of-specification currents or voltages and switching on the MOSFET 6 so that the fusible link 11 goes open circuit and the actuator 3 cannot operate. The circuit may therefore be used to provide a very high degree of immunity to unauthorised vehicle operation.

Although the circuit blocks 8, 9, 12, 13, 14, and 16 to 19 are shown as discrete blocks in Figure 2, any or all of them may be embodied within a single device, such as a micro-controller, for instance in the form of a VLSI integrated circuit with associated passive components.

## Claims

1. A tamper-resistant circuit comprising a load (3) which, in use, requires a first current and a control circuit (6, 8) arranged, when actuated, to supply the first current from an output thereof through the load (3), characterised by a link (11) arranged to pass the first current through the load (3) and arranged to become open circuit at a second current which is greater than the first current.

2. A circuit as claimed in Claim 1, characterised in that the control circuit (6, 8) comprises a semiconductor switch (6) connected in series with the link (11) and the load (3) and having a control electrode connected to pulse modulation means (8) for controlling current through the semiconductor switch (6).

3. A circuit as claimed in Claim 2, characterised in that the control means (8) is a pulse width modulator.

4. A circuit as claimed in Claim 2 or 3, characterised in that a sensing element (7) is connected in series with the semiconductor switch (6), the link (11) and the load (3) is connected to a control input of the pulse modulation means (8).

5. A circuit as claimed in Claim 4, characterised in that the sensing element (7) is a current-sensing resistor.

6. A circuit as claimed in any one of the preceding claims, characterised by a first comparator (13) arranged to switch on the semiconductor switch (6) when the current through the link (11) and the load (3) exceeds a predetermined current which is greater than the first current.

7. A circuit as claimed in any one of the preceding claims, characterised by a second comparator (14) arranged to switch on the semiconductor switch (6) when the voltage at a node of a series circuit comprising the semiconductor switch (6), the link (11) and the load (3) exceeds a predetermined voltage.

8. A circuit as claimed in any one of the preceding claims, characterised by a detector (9) connected to an enable input of the control circuit (6, 8).

9. A circuit as claimed in any one of the preceding claims, characterised by a diode (5) connected in series with the link (11) and the load (3) so as to block reverse current.

10. A circuit as claimed in any one of the preceding claims, characterised in that the load (3) comprises an actuator.

11. A circuit as claimed in any one of the preceding claims, characterised in being disposed within a tamper-resistant enclosure (1).

12. An engine control system characterised by including a circuit as claimed in any one of the preceding claims.
